# EUROPÄISCHE PATENTSCHRIFT

(11) **EP 1 736 786 B1**
(45) Veröffentlichungstag und Bekanntmachung des Hinweises auf die Patenterteilung: **01.06.2011**
(21) Anmeldenummer: 06012633.1
(22) Anmeldetag: 20.06.2006
(51) Int. Cl.: G01R 27/20, G01N 17/02

(54) **Isolationswiderstands-Messvorrichtung**
Apparatus for measuring insulation resistance.
Appareil de mesure d'une resistance d'isolation

(30) Priorität: 21.06.2005 DE 202005009752 U
(43) Veröffentlichungstag der Anmeldung: 27.12.2006
(73) Patentinhaber: TÜV Industrie Service GmbH, 80686 München (DE)
(72) Erfinder: Winter, Erwin, 80335 München (DE); Zauner, Christian, 86899 Landsberg am Lech (DE)
(74) Vertreter: Grünecker, Kinkeldey, Stockmair & Schwanhäusser Anwaltssozietät

(56) Entgegenhaltungen:
- GB-A- 2 223 851
- US-A- 3 999 121
- US-A1- 2003 164 770
- PATENT ABSTRACTS OF JAPAN Bd. 1995, Nr. 11, 26. Dezember 1995 (1995-12-26) & JP 07 198430 A (SHIZUOKA GASUKEN:KK; others: 02), 1. August 1995 (1995-08-01)

## Beschreibung

Die Erfindung betrifft eine Messvorrichtung zur Messung eines Isolationswiderstandes insbesondere von erdbedeckten, elektrisch isolierten Flüssiggastanks und/oder Rohrieitungen.

Gegenwärtig werden solche Tanks für Flüssiggas oder andere Fluide oder Rohrleitungen durch unterschiedliche Vorrichtungen oder Verfahren überprüft.

Es besteht beispielsweise die Möglichkeit, die entsprechende Überprüfung nach einer erfolgten Leerung des Tanks oder der Rohrleitung durch ein Wanddickenmessung mit einer Ultraschallmethode durchzuführen. Diese erfolgt in der Regel vom Inneren des entsprechenden Tanks oder der Rohrleitung her.

Es ist ebenfalls möglich, eine Messung nach dem Verfahren des katodischen Korrosionsschutzes durchzuführen. Dabei wird in der Regel eine Kupfersulfatsonde auf dem Erdreich platziert und über diese ein Prüfstrom auf das zu messende Objekt, wie Flüssiggastank oder Rohrleitung aufgebracht. Die Höhe des Stroms lässt dann in Verbindung mit einem sogenannten "K-Wert" (Bodenwiderstandskennwert) eine Aussage zu, ob das zu messende Objekt mit einem katodischen Korrosionsschutz ausgestattet werden soll.

GB 2 223 851 A offenbart eine Messvorrichtung zur Messung eines Isolationswiderstandes. Überprüft wird beispielsweise ein Rohr. Insgesamt sind drei Kontakte vorgesehen, von denen einer erster dem zu messenden Objekt, ein zweiter dem das zu messende Objekt umgebenden Erdreich und ein dritter Kontakt ebenfalls dem Erdreich zugeordnet sind. Der dritte Kontakt dient zur Einstellung eines Referenzwertes.

US 3.999, 121 A offenbart ein Korrosionsmessinstrument mit einer Gleichspannungsquelle in Form einer Batterie. Es werden ebenfalls drei Kontakte verwendet, wobei einer als Referenzkontakt dient.

US 2003/164770 A1 zeigt eine weitere Messeinrichtung zur Bestimmung eines elektrischen Widerstandes, um eine ausreichende Erdung eines entsprechenden Gegenstandes überprüfen zu können.

Der Erfindung liegt die Aufgabe zugrunde, eine Messvorrichtung der eingangs genannten Art dahingehend zu verbessern, dass ein entsprechender Isolationswiderstand in einfacher Weise und ohne Verfälschung durch andere Signale schnell und reproduzierbar ermittelt werden kann.

Diese Aufgabe wird durch die Merkmale des Anspruchs 1 gelöst.

Erfindungsgemäß weist die Messvorrichtung eine Gleichspannungsquelle und nur zwei Kontakte auf. Ein erster dieser Kontakte ist dem zu messenden Objekt, wie Flüssiggastank oder Rohrleitung zugeordnet. Ein zweiter dieser Kontakte ist dem das zu messende Objekt umgebenden Erdreich zugeordnet. Zwischen den Kontakten sind unterschiedliche Prüfspannungen anlegbar. Die Messvorrichtung weist weiterhin eine Auswerteeinrichtung zur Erfassung der Prüfspannung und eines entsprechenden Stromwerts zur Ermittlung des Widerstandswertes auf. Die entsprechende Prüfspannung liegt in einem Bereich von 60 bis 85 V und vorzugsweise in einem Bereich von 70 bis 80 V. Durch diese Spannungswerte wird eine Verfälschung durch vorhandene galvanische Elemente vermieden. Ansonsten würden diese galvanischen Elemente, wie beispielweise der Flüssiggastank, die Rohrleitung oder auch benachbart vom zu messenden Objekt angeordnete Tanks, Rohrleitung oder andere metallische Objekte, galvanische Spannungen in einer Größenordnung von ca. 0,4 V bis ca. 1,2 V erzeugen als elektrisches Potential zwischen Erdreich bzw. Masse und Tank oder als elektrisches Potential zwischen Masse und Rohrleitung bei Ausgleichsströmen von ca. 1000 Mikroampere bis 0,5 Mikroampere, die eine entsprechende Messung der Messvorrichtung bei geringeren Spannungsdifferenzen zum Teil stark beeinflussen oder auch verfälschen könnten.

Erfindungsgemäß ist eine intakte Isolierung, d.h. ausreichend Rohrisolationswiderstand von dem zu messenden Objekt mit geringem Arbeitsaufwand und mit gleichzeitig erhöhter Prüfqualität für feststellbar.

Erfindungsgemäß ist eine intakte Isolierung, d.h. ausreichend hoher Isolationswiderstand von dem zu messenden Objekt mit geringem Arbeitsaufwand und mit gleichzeitig erhöhter Prüfqualität feststellbar.

Um in einfacher Weise schnell einen entsprechenden Isolationswiderstand ermitteln zu können, kann die Messvorrichtung eine Anzeigeeinrichtung zur Darstellung von Messspannung und/oder Stromwert und/oder Widerstandswert aufweisen. Es besteht ebenfalls die Möglichkeit, dass die Anzeigeeinrichtung zwischen den vorgenannten Darstellungen der entsprechenden Werte umschaltbar ist. Weiterhin besteht die Möglichkeit, dass bei ausreichendem Isolationswiderstand ein entsprechendes optisches oder akustisches Signal ausgegeben wird.

Bei einem vorteilhaften Ausführungsbeispiel der Erfindung kann der Strom durch die Messspannung eingeprägt sein.

Um die Messvorrichtung zu bestimmten Zeitpunkten auf ihre korrekte Funktion zu überprüfen, kann diese zur Funktionskontrolle eine Prüftaste oder einen Normwiderstand aufweisen. Durch Betätigung der Prüftaste und zur Ermittlung des Normwiderstands wird dann festgestellt, ob beispielsweise durch die Erfassung von Prüfspannung und entsprechendem Stromwert sich der korrekte Widerstandswert ergibt.

Es besteht weiterhin die Möglichkeit, dass bei der Messvorrichtung die Messung wenigstens eines Widerstandswertes automatisiert ist. D.h., nach Einrichten der Messvorrichtung beim zu messenden Objekt und Initialisierung der Messvorrichtung erfolgt dann die Messung automatisch, wobei wenigstens ein Widerstandswert ermittelt wird. Vorzugsweise werden mehrere Widerstandswerte beispielsweise durch unterschiedliche Anordnung der entsprechenden Kontakte und/oder durch unterschiedliche Prüfspannungen ermittelt.

Um die Messvorrichtung unabhängig von äußeren Spannungsquellen zu gestalten, kann diese batteriebetrieben sein.

Um unterschiedliche Objekte überprüfen zu können, kann die Messvorrichtung tragbar sein. Dabei kann die Verbindung mit den entsprechenden Kontakten über lösbare Kabel oder dgl. erfolgen.

Insbesondere bei einer batteriebetriebenen Messvorrichtung kann es sich als vorteilhaft erweisen, wenn diese einen Spannungswandler zur Erzeugung einer ausreichend hohen Prüfspannung aufweist.

Um in einfacher Weise den zweiten Kontakt als einen Massekontakt ausbilden zu können, kann dieser als Erdspieß oder dgl. ausgeführt sein.

In der Praxis hat sich durch zahlreiche Feldversuche herausgestellt, dass Isolationswiderstände von erdbedeckten, elektrisch isolierten Flüssiggastanks und/oder Rohrleitungen von mehr als in etwa 50 kΩ als nicht isolationsgeschädigt zu betrachten sind. Dies entspricht beispielsweise einer Spannung von 1 V bei einem Strom von 20 µA.

Erfindungsgemäß wird allerdings in der Regel eine Prüfspannung in dem oben genannten Bereich verwendet, um Messfehler durch im Erdreich generierte galvanische Spannungseinkopplungen und Ausgleichsströme erheblich zu reduzieren. Dadurch ist eine Durchführung von einfachen Messungen zwischen beispielsweise Erdspieß und Domschacht des Tanks, Erdspieß und Gastank oder auch Domschacht und Gastank in einfacher Weise und reproduzierbar ohne Beeinflussung durch die genannten galvanischen Spannungseinkopplungen und Ausgleichsströme möglich.

Ansonsten könnte die Messung des Isolationswiderstandes durch das Vorhandensein von galvanischen Spannungen in einer Größenordnung von ca. 0,4 V bis ca. 1,2 V bei entsprechenden Ausgleichsströmen von ca. 1000 µA bis 0,5 µA das entsprechende Messsignal stark verfälscht werden.

Verfahrensmäßig wird entsprechend zur Messvorrichtung der Isolationswiderstand des zu messenden Objekts dadurch ermittelt, dass das zu messende Objekt elektrisch kontaktiert wird und zwischen diesem und Masse eine sich durch eine angelegte Messspannung ergebender Stromwert und aus Messspannung und gemessenem Stromwert ein Widerstandswert ermittelt wird, wobei die Messspannung im Wesentlichen eine Größenordnung größer ist als bei der Messung auftretende, im Erdreich generierte galvanische Spannungseinkopplungen.

Wie bereits ausgeführt, kann die entsprechende Messung zwischen Masse und Domschacht und/oder Masse und Gastank bzw. Rohrleitung und/oder Domschacht und Gastank bzw. Rohrleitung erfolgen.

Außerdem kann die Messung automatisch durchgeführt werden und bei einer Spannungsquelle mit relativ niedriger Spannung kann ein Spannungswandler eine ausreichend hohe Prüfspannung generieren. Dabei wird ein Widerstandswert von ungefähr mehr als 50 kΩ als ausreichender Isolationswiderstand betrachtet.

Im Folgenden wird die Erfindung anhand einer Figur näher erläutert.

Es zeigt:

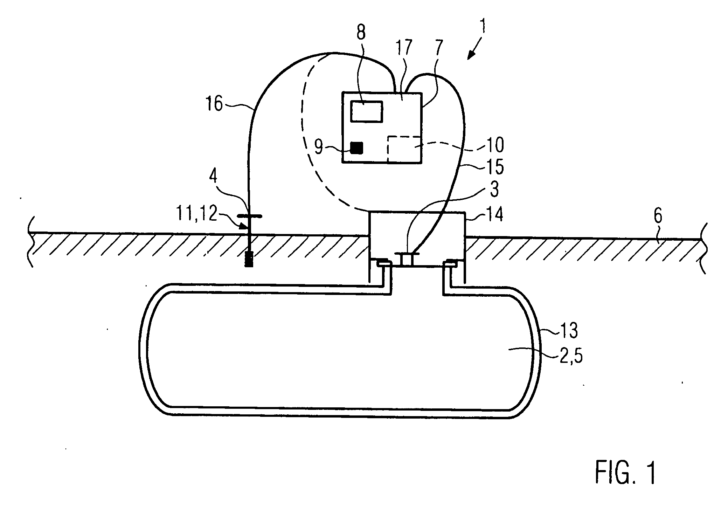

- Fig. 1: eine Seitenansicht einer erfindungsgemäßen Messvorrichtung.

In Fig. 1 ist als zu messendes Objekt 5 ein Flüssiggastank 2 in einem Erdreich 6 so angeordnet, dass er nahezu vollständig von diesem umgeben ist. Nur ein Domschacht 14 ist von außerhalb des Erdreichs 6 zum Nachfüllen des Flüssiggastanks 2 zugänglich. Der Flüssiggastank 2 ist von einer Isolierung 13 umgeben, die auch zwischen diesem und dem Domschacht 14 angeordnet ist.

Mittels einer erfindungsgemäßen Messvorrichtung 1 wird ein Isolationswiderstand des Flüssiggastanks relativ zum Erdreich, des Domschachtes relativ zum Flüssiggastank oder auch des Domschachtes relativ zum Erdreich ermittelt. Dazu sind entsprechende Kontakte 3 und 4 vorgesehen.

Bei dem dargestellten Ausführungsbeispiel ist ein erster Kontakt 3 mit einem Stutzen des Flüssiggastanks 2 verbunden, so dass der entsprechende Kontakt direkt dem Flüssiggastank zugeordnet ist. Der zweite Kontakt 4 dient als Massekontakt, wobei dieser durch einen in das Erdreich 6 eingesteckten Erdspieß 12 als Massekontakt 11 realisiert ist.

Die entsprechenden .Kontakte 3, 4 sind über eine Verbindung 15, 16, wie beispielsweise eine Kabelverbindung, mit einer Auswerteeinrichtung 7 als Teil der Messvorrichtung 1 verbunden. Diese Auswerteeinrichtung 7 kann ebenfalls eine entsprechende Spannungsquelle 17 enthalten sowie ebenfalls einen Spannungswandler 10, eine Anzeigeeinrichtung 8, eine Prüftaste 9 und dgl.

In Fig. 1 ist der zweite Kontakt 4 alternativ, s. die gestrichelte Darstellung, mit dem Domschacht 14 hergestellt. In diesem Fall würde die Isolierung zwischen Flüssiggastank 2 und Domschacht 14 überprüft.

Der Spannungswandler 10 wird insbesondere dazu verwendet, bei einer batteriebetriebenen Messvorrichtung eine entsprechende Batteriespannung mit dem bevorzugten Spannungswert im Bereich von ungefähr 60 bis 85 V oder vorzugsweise im Bereich von 70 bis 80 V zu generieren.

Mittels der Anzeigeeinrichtung 8 sind verschiedene Funktionen der Messvorrichtung 1 überprüfbar sowie auch beispielsweise Prüfspannung, die zwischen den Kontakten 3, 4 angelegt ist, sich ergebender Stromwert und aus Prüfspannung und Stromwert berechneter Isolationswiderstandswert.

Die Prüftaste 9 kann zum Eigentest der Messvorrichtung 1 dienen, indem beispielsweise die Messung über einen entsprechenden in der Vorrichtung enthaltenen Normwiderstand mit entsprechender Prüfspannung und sich ergebendem Stromwert durchgeführt wird.

Die Messvorrichtung 1 nach Fig. 1 ist insbesondere tragbar zusammen mit Auswerteeinrichtung 7, Verbindungen 15, 16 und Erdspieß 12. Der Kontakt 3 zwischen Verbindung 15 und zu messendem Objekt 5 kann in unterschiedlicher, lösbarer Weise erfolgen, wie beispielsweise durch eine Klammer oder dgl.

Gemäß der Erfindung besteht die Möglichkeit, trotz im Erdreich generierter, galvanischer Spannungseinkopplungen und entsprechender Ausgleichsströme den Isolationswiderstand schnell und genau zu messen, ohne dass diese Messung verfälscht wird. Dabei wird in der Regel ein Isolationswiderstand von ca. 50 kΩ oder mehr als ausreichend betrachtet, d.h., die entsprechende Isolation als ausreichend betrachtet. Statt eines Flüssiggastanks 2 kann auch eine entsprechende Rohrleitung oder dgl. in der entsprechenden Isolationseigenschaft und des zugehörigen Isolationswiderstandes mittels der erfindungsgemäßen Messvorrichtung überprüft werden.

## Patentansprüche

1. Isolationswiderstands-Messvorrichtung (1) zur Messung eines Isolationswiderstandes von erdbedeckten, elektrisch isolierten Flüssiggastanks (2) und/oder Rohrleitungen mit einer Gleichspannungsquelle (17) und nur zwei Kontakten (3, 4), von denen ein erster dem zu messenden Objekt (2, 5) und ein zweiter dem das zu messende Objekt umgebenden Erdreich (6) zugeordnet ist, wobei unterschiedliche Prüfspannungen zwischen den beiden Kontakten anlegbar sind, und mit einer Auswerteeinrichtung (7) zur Erfassung der Prüfspannung und eines entsprechenden Stromwertes zur Ermittlung des Widerstandswertes,
wobei die Prüfspannung in einem Bereich von 60 bis 85 V und vorzugsweise in einem Bereich von 70 bis 80 V liegt.

2. Isolationswiderstands-Messvorrichtung nach Anspruch 1, wobei diese eine Anzeigeeinrichtung (8) zur Darstellung von Prüfspannung und/oder Stromwert und/oder Widerstandswert aufweist.

3. Isolationswiderstands-Messvorrichtung nach Anspruch 1 oder 2, wobei ein Strom durch die Prüfspannung eingeprägt ist.

4. Isolationswiderstands-Messvorrichtung nach einem der vorangehenden Ansprüche, wobei dieses zur Funktionskontrolle eine Prüftaste (9) und einen Normwiderstand aufweist.

5. Isolationswiderstands-Messvorrichtung nach einem der vorangehenden Ansprüche, wobei die Messung wenigstens eines Widerstandswertes automatisiert ist.

6. Isolationswiderstands-Messvorrichtung nach einem der vorangehenden Ansprüche, wobei diese batteriebetrieben ist.

7. Isolationswiderstands-Messvorrichtung'nach einem der vorangehenden Ansprüche, wobei diese tragbar ist.

8. Isolationswiderstands-Messvorrichtung nach einem der vorangehenden Ansprüche, wobei diese einen Spannungswandler (10) zur Erzeugung der Prüfspannung insbesondere aus einer Batteriespannung aufweist.

9. lsolationswiderstands-Messvorrichtung nach einem der vorangehenden Ansprüche, wobei der zweite Kontakt ein Massekontakt (11), wie ein Erdspieß (12) oder dgl., ist.

10. Isolationswiderstands-Messvorrichtung nach einem der vorangehenden Ansprüche, wobei ein Widerstandswert von etwa mehr als 50 kΩ für eine Isolation des Flüssiggastanks (2) oder der Rohrleitung ausreichend ist.

## Claims

1. Insulation resistance measuring apparatus (1) for measuring an insulation resistance of buried, electrically insulated fluid tanks (2) and/or pipelines, with a dc voltage source (17) and only two contacts (3, 4), a first of which co-operates with the object (2, 5) to be measured and a second of which co-operates with the area of ground (6) surrounding the object to be measured, whereby different test voltages can be applied between the two contacts, and with an evaluation unit (7) for detecting the test voltage and a corresponding current value in order to determine the resistance value,
and the test voltage is within a range of from 60 to 85 V and preferably within a range of 70 to 80 V.

2. Insulation resistance measuring apparatus as claimed in claim 1, wherein the latter has a display unit (8) for displaying the test voltage and/or current value and/or resistance value.

3. Insulation resistance measuring apparatus as claimed in claim 1 or 2, wherein the test voltage is superimposed on a current.

4. Insulation resistance measuring apparatus as claimed in one of the preceding claims, wherein the latter has a test button (9) and a standard resistance for functional control purposes.

5. Insulation resistance measuring apparatus as claimed in one of the preceding claims, wherein the measurement of at least a resistance value is automated.

6. Insulation resistance measuring apparatus as claimed in one of the preceding claims, wherein the latter is battery operated.

7. Insulation resistance measuring apparatus as claimed in one of the preceding claims, wherein the latter is portable.

8. Insulation resistance measuring apparatus as claimed in one of the preceding claims, wherein the latter has a potential transformer (10) for generating the test voltage, in particular from a battery voltage.

9. Insulation resistance measuring apparatus as claimed in one of the preceding claims, wherein the second contact is an earth contact (11), such as an earth spike (12) or similar.

10. Insulation resistance measuring apparatus as claimed in one of the preceding claims, wherein a resistance value of approximately more than 50 kΩ is sufficient indication that the liquid tank (2) or pipeline is insulated.

## Revendications

1. Dispositif de mesure de résistance d'isolation (1) pour mesurer une résistance d'isolation de réservoirs de liquide (2) couverts par de la terre et isolés électriquement et/ou de canalisations avec une source de tension continue (17) et seulement deux contacts (3, 4), un premier contact étant associé à l'objet à mesurer (2, 5) tandis que le second est associé à la terre (6) qui entoure l'objet à mesurer, étant précisé que différentes tensions d'essai sont aptes à être appliquées entre les deux contacts, et avec un dispositif d'évaluation (7) pour relever la tension d'essai et une valeur de courant correspondante pour déterminer la valeur de résistance,
étant précisé que la tension d'essai est située dans une plage de 60 à 85 V et de préférence dans une plage de 70 à 80 V.

2. Dispositif de mesure de résistance d'isolation selon la revendication 1, étant précisé qu'il comporte un dispositif d'affichage (8) pour présenter la tension d'essai et/ou la valeur de courant et/ou la valeur de résistance.

3. Dispositif de mesure de résistance d'isolation selon la revendication 1 ou 2, étant précisé qu'un courant est appliqué grâce à la tension d'essai.

4. Dispositif de mesure de résistance d'isolation selon l'une des revendications précédentes, étant précisé qu'il comporte pour le contrôle de fonctionnement une touche d'essai (9) et une résistance étalon.

5. Dispositif de mesure de résistance d'isolation selon l'une des revendications précédentes, étant précisé que la mesure d'au moins une valeur de résistance est automatisée.

6. Dispositif de mesure de résistance d'isolation selon l'une des revendications précédentes, étant précisé qu'il fonctionne sur batterie.

7. Dispositif de mesure de résistance d'isolation selon l'une des revendications précédentes, étant précisé qu'il est portatif.

8. Dispositif de mesure de résistance d'isolation selon l'une des revendications précédentes, étant précisé qu'il comporte un transformateur de tension (10) pour produire la tension d'essai, en particulier à partir d'une tension de batterie.

9. Dispositif de mesure de résistance d'isolation selon l'une des revendications précédentes, étant précisé que le second contact est un contact de masse (11), tel qu'une perche de mise à la terre (12) ou un dispositif similaire.

10. Dispositif de mesure de résistance d'isolation selon l'une des revendications précédentes, étant précisé qu'une valeur de résistance de plus de 50 kΩ est suffisante pour une isolation du réservoir de liquide (2) ou de la canalisation.
